# EUROPEAN PATENT APPLICATION

(11) **EP 1 865 538 A1**
(43) Date of publication of application: **12.12.2007**
(21) Application number: 06730219.0
(22) Date of filing: 28.03.2006
(51) Int. Cl.: H01L 21/027, G03F 7/20, H01J 37/305

(54) **MULTI-COLUMN ELECTRON BEAM EXPOSURE DEVICE**

(30) Priority: 29.03.2005 JP 2005094302
(71) Applicant: ADVANTEST CORPORATION, Tokyo 179-0071 (JP)
(72) Inventor: YABARA, Hidefumi, e, Nerima-ku, Tokyo 1790071 (JP); MIYAZAWA, Kenichi, e, Nerima-ku, Tokyo 1790071 (JP); SAKAZAKI, Tomohiro, e, Nerima-ku, Tokyo 1790071 (JP); TANAKA, Kazuaki, e, Nerima-ku, Tokyo 1790071 (JP)
(74) Representative: Tetzner, Michael
(86) International application number: PCT/JP2006/306271
(87) International publication number: WO 2006/104139

(57) **Abstract**

A multi-column type electron beam exposure apparatus includes: plural column cells disposed over a wafer, each including an electron gun, deflector for deflecting an electron beam emitted by the electron gun, and exposure data receiving unit for receiving exposure data; and correction computing unit for calculating the exposure data for use in the column cells. The correction computing unit includes exposure data controlling unit and exposure data transmitting unit for each of the column cells. The exposure data transmitting unit encodes the exposure data corrected by the exposure data controlling unit to convert the data into serial data, converts the serial data into a light signal, and transmits the light signal. The exposure data receiving unit converts the light signal into an electric signal, and decodes the encoded exposure data to convert the data into parallel data.

## Description

### BACKGROUND OF THE INVENTION

### 1. Field of the Invention

The present invention relates to an electron beam exposure apparatus, and more particularly to a multi-column type electron beam exposure apparatus including plural columns which are disposed over a wafer, and which concurrently perform an exposure process.

### 2. Description of the Prior Art

Recently, an electron beam exposure apparatus has come into use for fine patterning in a lithography process for manufacture of a semiconductor device or the like.

The electron beam exposure apparatus has the feature of having good resolution but has the problem of having low exposure throughput, as compared to a photolithography apparatus. As opposed to the above apparatus, a multi-column type electron beam exposure apparatus, which is designed to improve the exposure throughput by being provided with plural column cells for subjecting a resist to patterning by electron beam irradiation, is contemplated. Although each of the column cells is equivalent to a column of a single-column type electron beam exposure apparatus, the entire multi-column enables an increase in the exposure throughput by a factor equivalent to the number of columns, because of undergoing processing as being in a parallel arrangement.

Related techniques include a multi-column type electron beam exposure apparatus that involves correcting pattern data according to misalignment of an optical axis of each column and then subjecting a wafer to exposure for the same concurrent patterning, as disclosed in Japanese Patent Application Laid-open Publication No. Hei 11-329322.

However, the multi-column type electron beam exposure apparatus has problems as given below.

In the conventional single-column type electron beam exposure apparatus, the amount of information in exposure data required for electron beam control is of the order of 18 gigabits per second (Gbps). For example, when 25 pairs of twisted pair cables are used to send a signal of 20 MHz for the purpose of transmitting the exposure data to the column, the required number of twisted pair cables is about 36.

The multi-column type electron beam exposure apparatus likewise requires about 36 twisted pair cables for transmission of the exposure data to each column, because of using the columns each equivalent to the column of the single-column type electron beam exposure apparatus. When the number of columns is 16, the transmission of the exposure data requires about 600 twisted pair cables.

Because of this, the twisted pair cables increase in weight and vibrations propagate from the cables to the columns. This vibration of columns may lead to position variation of electron beam to be exposed. This results in forming a different pattern from the exposure data. To lessen the influence of the vibrations from the twisted pair cables, it is contemplated to bend the twisted pair cables. However, this leads to an increase in a transmission load on an analog amplifier and hence to a reduction in the exposure throughput.

Incidentally, Japanese Unexamined Patent Application Publication No. Hei 5-82429 discloses an electron beam exposure apparatus. In the configuration of the above mentioned apparatus, a main body is disposed inside a clean room, a digital controller unit and others are disposed outside the clean room, and a serial transmission type optical cable is used to provide a connection between the main body and the controller unit. However, the Japanese Unexamined Patent Application Publication No. Hei 5-82429 gives no disclosure as to specific means for the serial transmission type, giving no consideration to problems involved in use.

### SUMMARY OF THE INVENTION

The present invention has been made in consideration for the foregoing problems inherent in the prior art. It is an object of the present invention to provide a multi-column type electron beam exposure apparatus capable of eliminating movements of electron beam to be exposed in column cells, thus transmitting exposure data to columns with accuracy, and thereby achieving high-precision exposure.

The above problems are solved by a multi-column type electron beam exposure apparatus, including: plural column cells disposed over a wafer, each including an electron gun, deflector for deflecting an electron beam emitted by the electron gun, and exposure data receiving unit for receiving exposure data; and correction computing unit for calculating the exposure data for use in the column cells, wherein the correction computing unit includes exposure data controlling unit and exposure data transmitting unit for each of the column cells, the exposure data transmitting unit encodes the exposure data corrected by the exposure data controlling unit to convert the data into serial data, converts the serial data into a light signal, and transmits the light signal, and the exposure data receiving unit converts the light signal into an electric signal, and decodes the encoded exposure data to convert the data into parallel data.

According to the present invention, the exposure data undergoes 8B10B encoding and thereby conversion into the serial data, which in turn is converted into the light signal and is transmitted. This reduces the number of cables for use in exposure data transmission. For example, the required number of cables is reduced from 36 to 1. The use of a small number of cables enables preventing a phenomenon in which vibrations from the cables cause vibrations of the columns and hence movements of the electron beam.

In the multi-column type electron beam exposure apparatus described above, prior to performing the encoding, the exposure data transmitting unit may calculate a code for exposure data error detection for the exposure data, combine the code for exposure data error detection into a block in units of a predetermined number of bits, and form an optical transmission frame for error detection, which is configured of a multiplexed combination of a predetermined number of blocks. The code for exposure data error detection may be calculated for each block representative of the exposure data. Further, the exposure data transmitting unit may calculate a code for error detection for the code for exposure data error detection, and append the calculated code to the optical transmission frame for error detection.

According to the present invention, the code for transmission error detection and correction (e.g., ECC) is calculated based on the exposure data, thereby enabling correction of a single-bit transmission error. Further, a mechanism is provided to detect whether or not the code for error detection and correction in itself is transmitted correctly, thereby ensuring that the exposure data is transmitted. This prevents transmission of erroneous exposure data and hence an erroneous exposure process, thereby preventing a reduction in throughput.

The multi-column type electron beam exposure apparatus described above may further include a stage controller unit that controls a wafer stage, and the exposure data transmitting unit may receive a signal having a predetermined period from the stage controller unit, and transmit the exposure data based on the signal. Moreover, the exposure data receiving unit may receive a signal having a predetermined period from the exposure data transmitting unit, and read out the received exposure data based on the signal. Further, the predetermined period may be longer than a transmission delay time on an exposure data signal line, which develops between the exposure data transmitting unit and the exposure data receiving unit.

According to the present invention, the signal having the period longer than the transmission delay time developing between the exposure data transmitting unit and the exposure data receiving unit is used to transmit the encoded exposure data and read out the received data. This makes it possible to absorb a varying transmission delay time which is contained in the transmission delay time, and which develops as varying from one encoding to another. Accordingly, the column cells securely receive the exposure data, and this makes it possible to emit electron beam at a predetermined spot.

### BRIEF DESCRIPTION OF THE DRAWINGS

Fig. 1 is an illustration of the configuration of a multi-column type electron beam exposure apparatus according to the present invention.
Fig. 2 is an illustration of the configuration of a column cell for the exposure apparatus shown in Fig. 1.
Fig. 3 is a diagram showing the relative connections of signals between a correction computing unit and an analog column controller unit.
Fig. 4 is a block diagram showing the flow of exposure data processing from a digital controller unit to a DAC unit.
Fig. 5 is a table showing an example of the configuration of an optical transmission frame.
Fig. 6 is a block diagram showing the flow of exposure data processing for error detection and correction.
Figs. 7A and 7B are illustrations showing an example of the optical transmission frame before and after a bit shift process, respectively.
Figs. 8A to 8C are illustrations of assistance in explaining a process for scattering a single-bit error across plural blocks.
Figs. 9A to 9F are timing charts of assistance in explaining the fixing of delay.

### DESCRIPTION OF THE PREFERRED EMBODIMENTS

An embodiment of the present invention will be described below with reference to the accompanying drawings.

Firstly, description will be given with regard to the configuration of a multi-column type electron beam exposure apparatus. Secondly, description will be given with regard to the configuration and operation of an exposure data transmitter unit that transmits exposure data from a correction computing unit to a column cell unit. Thirdly, description will be given with regard to the configuration of an optical transmission frame containing transmitted exposure data as a constituent. Finally, description will be given with regard to a fixed delay in transmission.

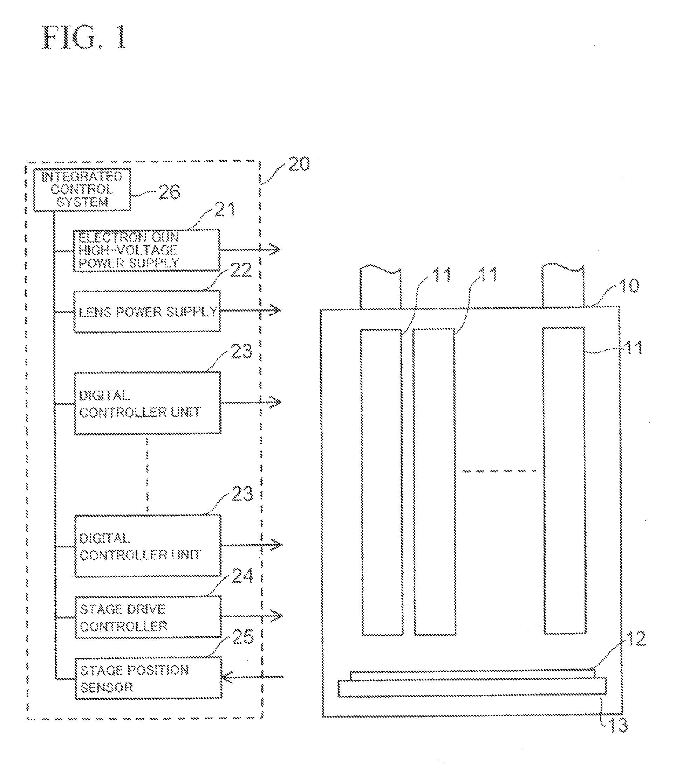

Fig. 1 is a schematic illustration of the configuration of a multi-column type electron beam exposure apparatus according to the embodiment of the present invention. The multi-column type electron beam exposure apparatus is broadly divided into an electron beam column 10 and a controller unit 20 that controls the electron beam column 10. Of these, the electron beam column 10 is configured of plural equivalent column cells 11, e.g., 16 column cells 11. Every column cell 11 is configured of the same unit to be described later. A wafer stage 13 having, for example, a 300-mm-thick wafer 12 loaded thereon is disposed under the column cells 11.

The controller unit 20 includes an electron gun high-voltage power supply 21, a lens power supply 22, a digital controller unit 23, a stage drive controller 24, and a stage position sensor 25. Of these, the electron gun high-voltage power supply 21 provides power supply to drive electron guns of the column cells 11 in the electron beam column 10. The lens power supply 22 provides power supply to drive electromagnetic lenses of the column cells 11 in the electron beam column 10. The digital controller unit 23 is an electric circuit that controls parts of the column cells 11, and produces a high-speed deflection output or the like. The corresponding number of digital controller units 23 is provided for the number of column cells 11. The stage drive controller 24 effects movement of the wafer stage 13 so that the wafer 12 is irradiated at a desired spot with an electron beam, based on position information from the stage position sensor 25. The above parts 21 to 25 are subject to integrated control by an integrated control system 26 such as a workstation.

In the multi-column type electron beam exposure apparatus mentioned above, every column cell 11 is configured of the same column unit.

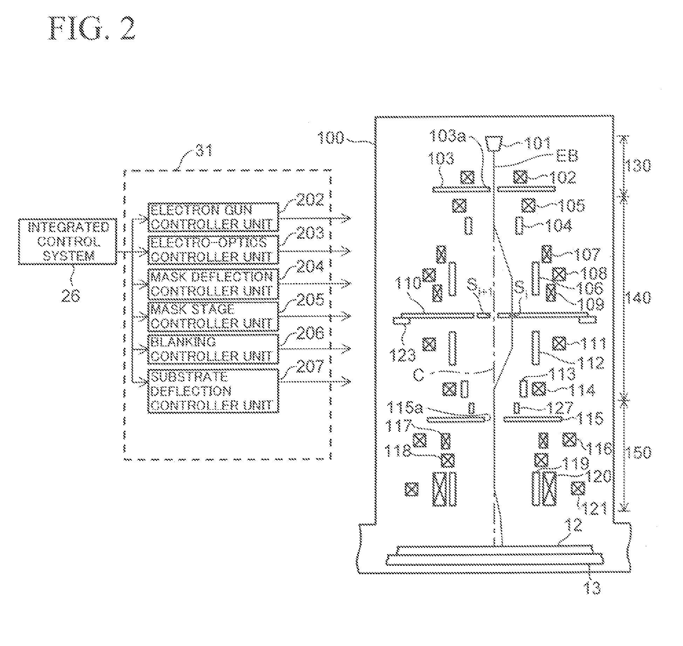

Fig. 2 is an illustration of the configuration of the column cell 11 for use in the multi-column type electron beam exposure apparatus.

The column cell 11 is broadly divided into an exposure unit 100 and a column cell controller unit 31 that controls the exposure unit 100. Of these, the exposure unit 100 is configured of an electron beam generator 130, a mask deflector unit 140, and a substrate deflector unit 150.

In the electron beam generator 130, an electron beam EB emitted from an electron gun 101 is converged in a first electromagnetic lens 102, and then passes through a rectangular aperture 103a in a beam shaping mask 103 so that the electron beam EB is shaped into a rectangular form in cross section.

After that, the electron beam EB is focused through a second electromagnetic lens 105 of the mask deflector unit 140 onto an exposure mask 110. Then, the electron beam EB is deflected to a given pattern S formed on the exposure mask 110 by first and second electrostatic deflectors 104 and 106 so that the electron beam EB is shaped into the form of the pattern S in cross section.

Incidentally, though the exposure mask 110 is fixed to a mask stage 123, the mask stage 123 can be moved in a horizontal plane. To use the pattern S lying beyond the range of deflection (or the region of beam deflection) by the first and second electrostatic deflectors 104 and 106, movement of the pattern S into the region of beam deflection is accomplished by movement of the mask stage 123.

Third and fourth electromagnetic lenses 108 and 111 disposed over and under the exposure mask 110, respectively, serve to focus the electron beam EB on a substrate by regulating the amount of current through the lenses 108 and 111.

After passing through the exposure mask 110, the electron beam EB is deflected back to an optical axis C by third and fourth electrostatic deflectors 112 and 113, and is then reduced in size through a fifth electromagnetic lens 114.

The mask deflector unit 140 is provided with first and second correction coils 107 and 109, and the coils 107 and 109 correct aberration of beam deflection that occurs in the first to fourth electrostatic deflectors 104, 106, 112 and 113.

After that, the electron beam EB passes through an aperture 115a in a masking shield 115 that constitutes the substrate deflector unit 150, and is then thrown onto the substrate through first and second electromagnetic projection lenses 116 and 121. Thereby, an image of the pattern on the exposure mask 110 is printed onto the substrate at a predetermined reduction ratio, such as a reduction ratio of 1/60.

The substrate deflector unit 150 is provided with a fifth electrostatic deflector 119 and an electromagnetic deflector 120, and the deflectors 119 and 120 deflect the electron beam EB to the substrate so that the image of the pattern on the exposure mask is projected onto the substrate at a predetermined spot.

The substrate deflector unit 150 is further provided with third and fourth correction coils 117 and 118 for correcting aberration of deflection of the electron beam EB on the substrate.

The column cell controller unit 31 includes an electron gun controller unit 202, an electro-optics controller unit 203, a mask deflection controller unit 204, a mask stage controller unit 205, a blanking controller unit 206, and a substrate deflection controller unit 207. Of these, the electron gun controller unit 202 controls the electron gun 101 to control an accelerating voltage on the electron beam EB, the conditions of beam emission thereof, or the like. The electro-optics controller unit 203 controls the amount of current applied to the electromagnetic lenses 102, 105, 108, 111, 114, 116 and 121, and adjusts the magnification, focal point, and the like of electro-optics constituted by the electromagnetic lenses. The blanking controller unit 206 deflects the electron beam EB generated before the start of an exposure on to the masking shield 115 by controlling the voltage applied to a blanking electrode 127, and thus preventing the electron beam EB from being applied to the substrate before the exposure.

The substrate deflection controller unit 207 controls an applied voltage to the fifth electrostatic deflector 119 and the amount of current applied to the electromagnetic deflector 120 so as to deflect the electron beam EB onto the substrate at a predetermined spot. The above described units 202 to 207 are subject to integrated control by the integrated control system 26 such as the workstation.

### (The configuration and operation of the exposure data transmitter unit)

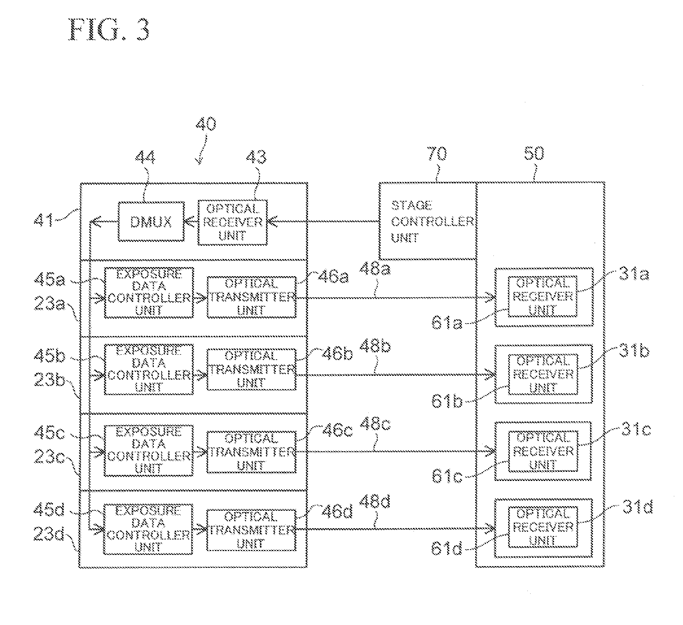

Fig. 3 is a diagram showing the relative connections of signals between a correction computing unit 40 and an analog column controller unit 50. Description is herein given for the multi-column type electron beam exposure apparatus configured of four columns.

The correction computing unit 40 is configured of digital controller units 23a to 23d that control electron beams emitted in the columns, and an integrated digital controller unit 41 that performs integrated control on the digital controller units 23a to 23d.

The integrated digital controller unit 41 is configured of an optical receiver unit 43 and a DMUX (demultiplexer) 44.

The digital controller units 23a to 23d are configured of exposure data controller units 45a to 45d, respectively, and optical transmitter units 46a to 46d, respectively.

The analog column controller unit 50 is configured of column cell controller units 31a to 31d that control the column cells 11. The column cell controller units 31a to 31d include optical receiver units 61a to 61 d, respectively.

The digital controller units 23a to 23d are connected to the column cell controller units 31a to 31d, respectively, by transmission lines 48a to 48d, respectively.

Transmission of exposure data signals between the correction computing unit 40 and the analog column controller unit 50 configured as mentioned above is accomplished in the following manner.

The integrated digital controller unit 41 receives stage position data and distributes the received stage position data to the digital controller units 23a to 23d. The integrated digital controller unit 41 also receives a reference clock from a stage controller unit 70 and transmits the reference clock to the digital controller units 23a to 23d.

In the digital controller units 23a to 23d, the exposure data controller units 45a to 45d execute processing according to the electron beams emitted in the column cells based on the stage position data from the integrated digital controller unit 41, and then the optical transmitter units 46a to 46d transmit the data to the optical receiver units 61a to 61d, respectively.

In the column cell controller units 31 a to 31 d, the optical receiver units 61 a to 61 d receive the exposure data transmitted from the digital controller units 23a to 23d, respectively.

The correction computing unit 40 receives the reference clock from the stage controller unit 70 and distributes the reference clock to the digital controller units 23a to 23d for synchronization. The reference clock is transmitted by a pulse transformer. A 1M clock is also received as the reference clock. The 1M clock is used as a timing signal for fixing a data delay between the optical transmitter and the optical receiver, as will be described later.

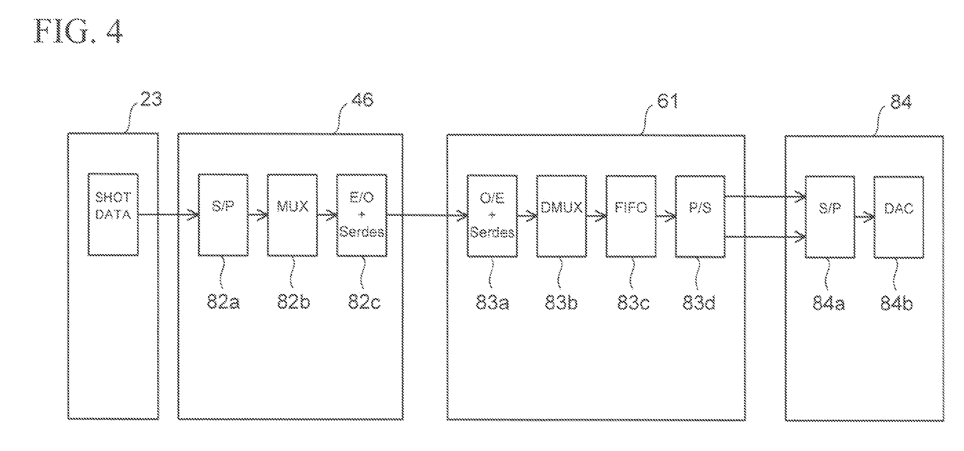

Fig. 4 is a block diagram showing the flow of exposure data processing from the exposure data controller unit 45 to a deflection signal converter/amplifier unit 84 of the analog column controller unit 50.

The optical transmitter unit 46 is configured of a S/P (serial-parallel converter) unit 82a that converts a serial signal into a parallel signal, a MUX (multiplexer) unit 82b that multiplexes demultiplexed signals into one, and a SERDES (serializer/deserializer) unit 82c that converts the parallel signal into the serial signal by performing 8B10B encoding so as to send 8 bits of data as 10 bits. The optical receiver unit 61 is configured of a SERDES unit 83a that converts the serial signal into the parallel signal by performing 10B8B decoding to decode 10 bits of data into 8 bits of data, a DMUX unit 83b that demultiplexes the signal multiplexed by the multiplexer, a first-in first-out (FIFO) memory 83c, and a P/S (parallel-serial converter) unit 83d that converts the parallel signal into the serial signal. The deflection signal converter/amplifier unit 84 is configured of an S/P unit 84a that converts the serial signal into the parallel signal, and a DAC (digital-to-analog converter) unit 84b that converts digital data into analog data.

Shot data corrected by the exposure data controller unit 45 is converted into serial data, which in turn is transmitted to the optical transmitter unit 46. In the optical transmitter unit 46, the S/P unit 82a converts the transmitted shot data from the serial data to parallel data, and the MUX unit 82b multiplexes the demultiplexed signals into an optical transmission frame. After that, the SERDES unit 82c performs 8B10B encoding to convert the parallel data into the serial data. After conversion into the serial data, an electric signal is converted into a light signal, which in turn is transmitted.

The SERDES unit 82c converts a parallel signal of 8 bits wide into 10 bits of serial data. At this time, 8B10B encoding is performed to convert 8 consecutive bits of data into 10 corresponding bits of data. The use of this encoding enables synchronization between the transmitting and receiving sides and hence enables error correction. Incidentally, the number of clocks required for the encoding process varies from one encoding to another, and a transmission delay contains a varying component.

Moreover, the 8B10B encoding function eliminates a long-running succession of zeros or ones and thus enables the receiving side to correctly receive data. Further, the 8B10B encoding has the advantage of achieving a good DC balance, because it encodes data with any length so that the number of zeros in the data is approximately equal to the number of ones therein.

In the optical receiver unit 61, the SERDES unit 83a receives the light signal from the optical transmitter unit 46, converts the light signal into an electric signal, and converts serial data into parallel data by performing 10B8B decoding to decode 10 bits of data into 8 bits of data. The DMUX unit 83b restructures the signal converted into the parallel data to form deflection unit data. The restructured data is stored in the FIFO memory 83c. The P/S unit 83d converts the data into serial data, which is then transferred to the deflection signal converter/amplifier unit 84. The S/P unit 84a converts the serial data into parallel data, and the DAC unit 84b converts the data into analog data. After that, electron beam irradiation takes place based on the analog data, thereby forming a desired pattern.

### (The configuration of the optical transmission frame)

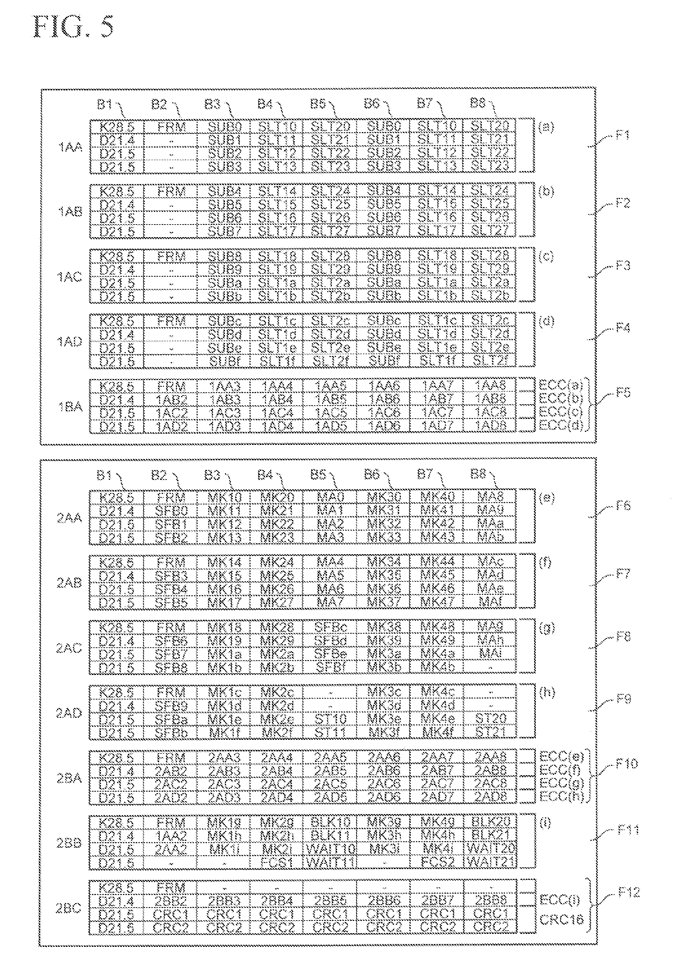

Fig. 5 shows an example of the configuration of the optical transmission frame. In Fig. 5, there are shown 12 optical transmission frames (F 1 to F12), and one optical fiber cable is used to transmit data in each of the optical transmission frames. The optical transmission frame is configured of multiplexed data into which the MUX unit 82b multiplexes exposure data, a control code required for the SERDES, and so on. Each of the optical transmission frames is configured of a multiplexed combination of 8 blocks (B 1 to B8), each of which is composed of 4 bytes of data.

For example, the block B1 in the frame F1 is configured of a control code required for the SERDES unit to perform 8B 1 0B encoding, and the block B2 therein is configured of an 8-bit frame number (FRM) that identifies the optical transmission frame. The blocks B3 to B8 in the frame F1 are configured of exposure data for controlling a voltage applied to the deflector and the amount of current applied to the deflector.

It is important to ensure that the exposure data as mentioned above is transmitted from the digital controller unit 23 to the column cell controller unit 31. However, the electron beam exposure apparatus involves problems. Specifically, one problem is as follows: when transmission of erroneous exposure data to the column cell controller unit 31 takes place and results in erroneous exposure, an exposure process has to go back to the start even if the exposure process has worked properly partway. Another problem is as follows: when a data transmission error is detected through data for error detection at the exposure data receiving side, the receiving side submits a resend request to the transmitting side, and during this time, the exposure process is stopped, resulting in a reduction in exposure process throughput. Still another problem is as follows: when the data for error detection at the exposure data receiving side is not transmitted correctly, a situation can possibly arise where error detection becomes impossible and hence the exposure process takes place without recognition of errors.

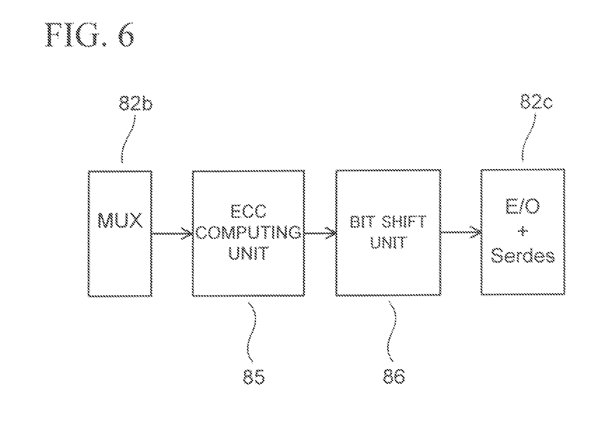

To handle the above problems, the apparatus according to the embodiment performs processing required for error detection and correction, which follows the multiplexing of the exposure data and is followed by the 8B10B encoding by the SERDES unit, as shown in Fig. 6.

With the optical transmission frame according to the embodiment, an ECC computing unit 85 generates a code for transmission error detection and correction from the optical transmission frame configured of the exposure data, and forms the optical transmission frame for error detection and correction (e.g., the frame F5, F10 or F12 shown in Fig. 5), which is configured of the code.

The code for error correction is calculated for each block in the optical transmission frame for the exposure data, and is stored in a predetermined block in a predetermined optical transmission frame for error detection and correction. For example, 1 byte of ECC (error correcting code) is calculated for 32 bits of data in the block B3 in the frame F1 shown in Fig. 5, and is stored in a 1-byte area (i.e., a location indicated at 1AA3 in Fig. 5) in the block B3 in the optical transmission frame F5 for error detection and correction. A Hamming code, for example, is used as the ECC.

Appending the ECC ensures that an error can be corrected if it is a single-bit error in transmitted exposure data.

When an error occurs in the code for error correction (or a check byte) in itself generated by ECC encoding, error correction for exposure data cannot be done properly, resulting in deterioration in the accuracy of exposure.

Thus, the apparatus according to the embodiment is further provided with a check mechanism in order to enable detection of an error in the ECC check byte in itself. One check mechanism generates CRC (cyclic redundancy check code) from the ECC check byte. In the embodiment, for example, CRC 16 is generated from 9 bytes of ECC check byte and is stored in a predetermined frame (F12). The data receiving side performs error detection on the CRC 16. If there is no error in the ECC check byte, the ECC check byte is used to check whether or not exposure data is transmitted normally. If a single-bit error occurs in the exposure data, an ECC error correcting function is used to correct the data value. If a double-bit or multiple-bit error is found in the exposure data, the data receiving side informs the transmitting side of the error.

Description will now be given with regard to a bit shift process required for the above-mentioned error detection and correction to function effectively.

8B10B encoding is employed for exposure data transmission according to the embodiment. Because of the 8B10B encoding, a single-bit error in 10 bits on the transmission line leads to a bit error and hence to an 8-bit burst error at the maximum, whenever 10B8B decoding takes place after transmission.

In order to prevent the occurrence of the error as mentioned above, the apparatus according to the embodiment performs a bit shift on exposure data to shift bits, bit by bit, in consecutive blocks and thereby regularly converts the values of the bits that constitute the blocks, prior to performing the 8B10B encoding.

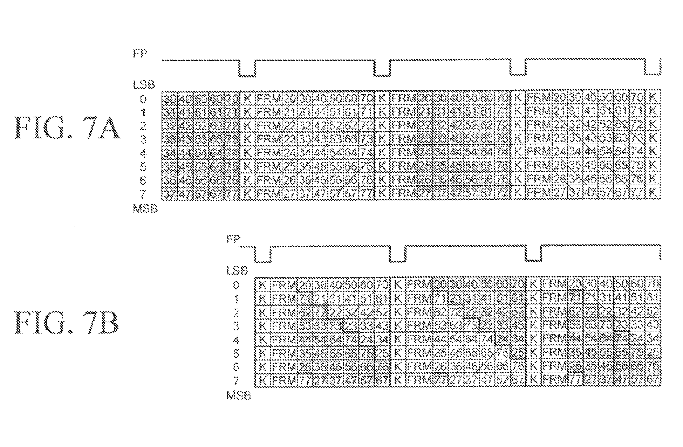

Figs. 7A and 7B are illustrations of assistance in explaining the bit shift process for the optical transmission frame. The blocks in the optical transmission frame are each composed of 32 bits and are consecutively configured as aligned by bit position. One byte of data alone in each block is observed in Figs. 7A and 7B for sake of simplicity of explanation.

Fig. 7A shows the optical transmission frame inputted to a bit shift unit 86 at predetermined timing. The bit shift involves inputting consecutive optical transmission frames to the bit shift unit 86; performing the bit shift to shift bits in consecutive blocks in the optical transmission frame, bit position by bit position, so that one bit lags another by a predetermined time interval; and producing an output. In Fig. 7A, the first bit row is outputted so as to lag the zeroth bit row by one block. In Fig. 7A, the second bit row is likewise outputted so as to lag the first bit row by one block.

Fig. 7B shows the consecutive optical transmission frames after the bit shift. As shown in Fig. 7B, the values of the bits in the block composed of 8 bits are regularly scattered across other plural blocks by the bit shift.

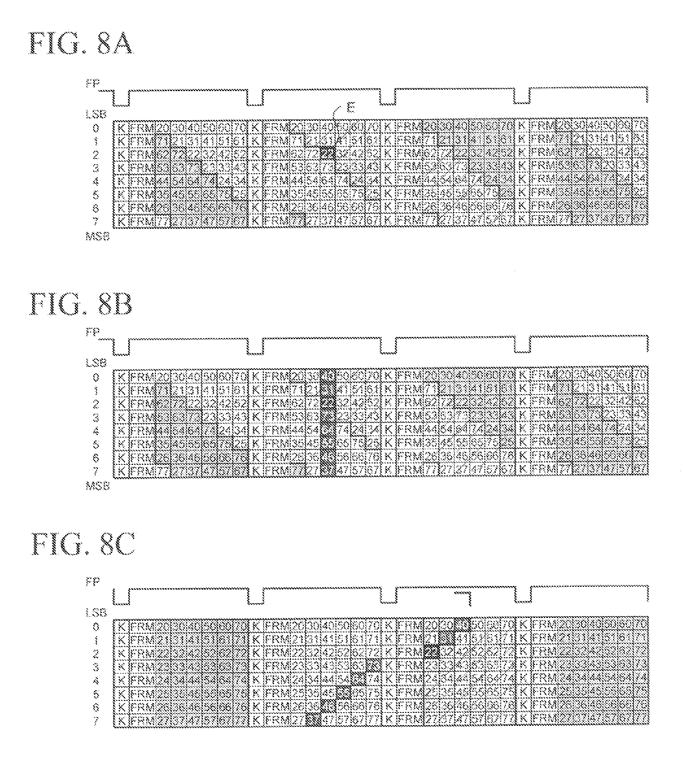

Figs. 8A to 8C are conceptual illustrations of assistance in explaining the scattering of an error at the occurrence of a single-bit error in exposure data during transmission.

When nBmB encoding is employed, transmitted data undergoes mBnB decoding. Thus, the single-bit error leads to conversion of the data into quite different data from the data before transmission.

It is assumed that a single-bit error E alone occurs during transmission, as shown in Fig. 8A. Fig. 8B shows a situation where data in a block containing an erroneous bit occurring during transmission affects a bit string after conversion by mBnB decoding. In other words, even the single-bit error results in consecutive burst errors.

Even in such cases, a reverse bit shift to the bit shift performed at the transmitting side is performed to thereby decompress an error-free portion into correct data and scatter the errors in data in a burst error portion as shown in Fig. 8C. Therefore, the errors are not contained intensively in one block but are scattered bit by bit across plural blocks. This enables error correction using the ECC calculated for each block, and thus makes it possible to transmit exposure data with accuracy.

### (Regarding the fixed delay)

Description will now be given with regard to the fixed delay in transmission.

When the exposure data transmission described with reference to Fig. 4 involves a transmission delay time containing a varying component that develops as varying from one code conversion to another, electron beam irradiation at a calculated spot becomes impossible due to a delay in exposure data transmission, even if the spot of electron beam irradiation is calculated allowing for a predicted delay in measurement or computing.

As opposed to this, fixing the delay time in advance enables also calculating the transmission delay at the fixed timing and thus enables electron beam irradiation at a desired spot. The fixing of the delay time is such that the time lags behind possible transmission delays, thereby enabling absorption of variations in the transmission delay.

It has been shown that an exposure data delay time varies greatly along an exposure data transmission path shown in Fig. 4, in particular from the SERDES unit 82c of the optical transmitter unit 46 to the FIFO memory 83c of the optical receiver unit 61. Therefore, the fixing of the delay in exposure data transmission is such that the delay lags behind the delay time during the above interval to absorb the transmission delay time.

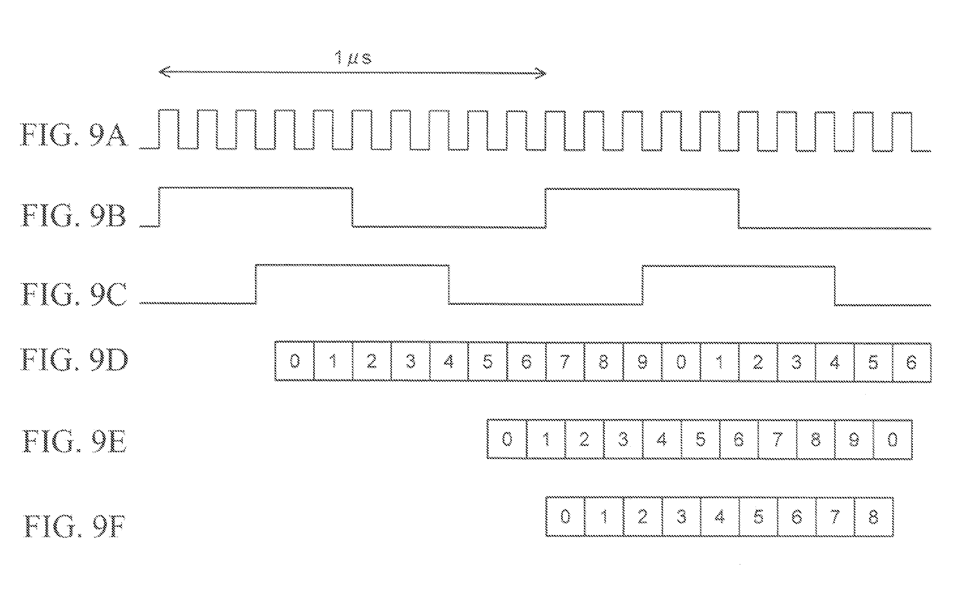

Figs. 9A to 9F are timing charts of assistance in explaining the absorption of the transmission delay time.

Fig. 9A shows a 10-MHz clock. Fig. 9B shows a 1-MHz reference clock in the optical receiver unit 61. Fig. 9C shows a 1-MHz reference clock in the optical transmitter unit 46. The optical receiver unit 61 and the optical transmitter unit 46 receive the 1-MHz reference clock from the stage controller unit 70, and the optical transmitter unit 46 lags in timing behind the optical receiver unit 61 because of a cable delay.

As shown in Fig. 9D, the optical transmitter unit 46 assembles and transmits data having the frame number "0" in the optical transmission frame in synchronization with the rising edge of a timing signal of 1 MHz. A delay occurs before the data reaches the DMUX unit 83b of the optical receiver unit 61. Thus, the optical receiver unit 61 receives the data after a time lag, as shown in Fig. 9E. The optical receiver unit 61 starts writing data into the FIFO memory 83c, starting with the received data having the frame number "0." Then, the optical receiver unit 61 starts reading in synchronization with the rising edge of the 1-MHz clock shown in Fig. 9B. In the manner as above mentioned, a fixed delay of about 1 µs can always develop between the SERDES unit 82c of the optical transmitter unit 46 and the SERDES unit 83a of the optical receiver unit 61.

In the multi-column type electron beam exposure apparatus according to the embodiment, the position of the wafer stage is measured at a sampling cycle of 10 MHz. Thus, fixing the delay time at 1 µs makes it possible to correct exposure data for electron beam irradiation, with the position of the wafer stage taking into consideration.

In the multi-column type electron beam exposure apparatus according to the embodiment, the delay time is fixed at 1 µs between the optical transmitter units 46a to 46d and the optical receiver units 61 a to 61 d and between the stage controller unit 70 and the integrated digital controller unit 41, thereby enabling absorption of variations in transmission delay for all the four columns.

As described above, the apparatus according to the embodiment performs 8B10B encoding on exposure data to convert the data into serial data and transmits the serial data by optical communication. This reduces the number of transmission cables and thus enables eliminating movements of an electron beam to be exposed due to vibrations from the transmission cables.

Moreover, the code for transmission error detection and correction (e.g., ECC) is calculated based on exposure data, thereby enabling correction of a single-bit transmission error. Further, the mechanism is provided to detect whether or not the code for error detection and correction in itself is transmitted correctly, thereby ensuring that correct exposure data is transmitted. Furthermore, even when 8B10B encoding is employed, the bit shift is performed on data that constitutes the frame, thereby preventing exposure data from developing a burst error. This prevents transmission of erroneous exposure data and hence an erroneous exposure process, thereby preventing a reduction in throughput.

Moreover, for transmission by optical communication, a common synchronization signal is externally applied to the optical transmitter unit and the optical receiver unit. The synchronization signal is fixed so as to lag behind the delay time developing during optical transmission. This absorbs a varying transmission delay time contained in the transmission delay time and developing as varying from one encoding to another, thereby enabling accurate calculation of the spot of electron beam irradiation.

Although in the embodiment the fixed delay time is set at 1 µs, the fixed delay time is not limited to this but may be set at 100 ns, for example.

## Claims

1. A multi-column type electron beam exposure apparatus, comprising:
a plurality of column cells disposed over a wafer, each including an electron gun, deflector for deflecting an electron beam emitted by the electron gun, and exposure data receiving unit for receiving exposure data; and
correction computing unit for calculating the exposure data for use in the column cells,
wherein the correction computing unit includes exposure data controlling unit and exposure data transmitting unit for each of the column cells,
the exposure data transmitting unit encodes the exposure data corrected by the exposure data controlling unit to convert the data into serial data, converts the serial data into a light signal, and transmits the light signal, and
the exposure data receiving unit converts the light signal into an electric signal, and decodes the encoded exposure data to convert the data into parallel data.

2. The multi-column type electron beam exposure apparatus according to claim 1, wherein, prior to performing the encoding, the exposure data transmitting unit combines the exposure data into a block in units of a predetermined number of bits, and forms an optical transmission frame for exposure data, which is configured of a multiplexed combination of a predetermined number of blocks.

3. The multi-column type electron beam exposure apparatus according to claim 1, wherein, prior to performing the encoding, the exposure data transmitting unit calculates a code for exposure data error detection for the exposure data, combines the code for exposure data error detection into a block in units of a predetermined number of bits, and forms an optical transmission frame for error detection, which is configured of a multiplexed combination of a predetermined number of blocks.

4. The multi-column type electron beam exposure apparatus according to claim 3, wherein the code for exposure data error detection is calculated for each block representative of the exposure data.

5. The multi-column type electron beam exposure apparatus according to any one of claims 3 and 4, wherein the exposure data transmitting unit calculates a code for error detection for the code for exposure data error detection, and appends the calculated code to the optical transmission frame for error detection.

6. The multi-column type electron beam exposure apparatus according to any one of claims 3 and 4, wherein the exposure data transmitting unit shifts, bit by bit, the exposure data configured of a predetermined number of consecutive blocks aligned by bit position, in a direction of the consecutive blocks.

7. The multi-column type electron beam exposure apparatus according to claim 3, wherein the code for exposure data error detection is ECC (error correcting code).

8. The multi-column type electron beam exposure apparatus according to claim 5, wherein the code for error detection is CRC (cyclic redundancy check code).

9. The multi-column type electron beam exposure apparatus according to claim 1, further comprising a stage controller unit that controls a wafer stage,
wherein the exposure data transmitting unit receives a signal having a predetermined period from the stage controller unit, and transmits the exposure data based on the signal.

10. The multi-column type electron beam exposure apparatus according to claim 1, wherein the exposure data receiving unit receives a signal having a predetermined period from the exposure data transmitting unit, and reads out the received exposure data based on the signal.

11. The multi-column type electron beam exposure apparatus according to any one of claims 9 and 10, wherein the predetermined period is longer than a transmission delay time of an exposure data signal that develops between the exposure data transmitting unit and the exposure data receiving unit.

12. The multi-column type electron beam exposure apparatus according to claim 11, wherein the correction computing unit further includes integrated exposure data controlling unit for performing integrated control on the exposure data controlling unit, and the integrated exposure data controlling unit receives the signal having the predetermined period from the stage controller unit through a pulse transformer, and transmits the signal to the exposure data transmitting unit.
